# EUROPEAN PATENT APPLICATION

(11) **EP 2 781 528 A1**
(43) Date of publication of application: **24.09.2014**
(21) Application number: 12850144.2
(22) Date of filing: 15.11.2012
(51) Int. Cl.: C08F 290/06, B23K 26/00, B23K 26/36, B23K 26/38, C08L 71/10, H01L 21/302, H01L 21/312, H01L 21/768, H01L 23/532

(54) **CURABLE COMPOSITION, COMPOSITION FOR APPLICATION, CURED FILM, LASER PROCESSING METHOD, AND MANUFACTURING METHOD FOR MULTI-LAYER WIRING STRUCTURE**

(30) Priority: 18.11.2011 JP 2011252663
(71) Applicant: Asahi Glass Company, Limited, Chiyoda-ku Tokyo 100-8405 (JP)
(72) Inventor: ITO, Masahiro, Tokyo 100-8405 (JP); TSURUOKA, Kaori, Tokyo 100-8405 (JP); KUWANA, Yasuhiro, Tokyo 100-8405 (JP); NAGAI, Yusuke, Tokyo 100-8405 (JP)
(74) Representative: Müller-Boré & Partner Patentanwälte PartG mbB
(86) International application number: PCT/JP2012/079704
(87) International publication number: WO 2013/073638

(57) **Abstract**

To provide a curable composition from which a cured film having a low dielectric constant and a low water-absorption and being capable of laser processing, is obtained, a laser processing method of the cured film, and a process for producing a multilayer wiring structure.

A curable composition comprising a fluorinated polyarylene prepolymer (A) having a crosslinkable functional group, a laser processing method comprising irradiating a cured film obtained by curing the composition with laser light to remove a part of the cured film, and a process for producing a multilayer wiring structure, comprising a step of forming a via hole in an insulation film made of the cured film by the processing method.

## Description

### TECHNICAL FIELD

The present invention relates to a curable composition to which laser ablation processing can be performed, a coating composition containing the curable composition, a cured film obtainable by curing the curable composition, a laser processing method of the cured film and a process for producing a multilayer wiring structure by means of the laser processing method.

### BACKGROUND ART

A polyimide is used as a material for an insulation film for a multilayer wiring structure such as a thin film transistor (TFT), but a polyimide has a relatively high dielectric constant and a high water absorption, and therefore it is insufficient in performance or reliability of a device.

As a material for an insulation film having a low dielectric constant and a low water absorption, it has been proposed to produce a multilayer wiring structure by using a fluorinated cyclic polymer such as CYTOP (tradename) manufactured by Asahi Glass Company, Limited (e.g. Patent Document 1).

By the way, for a multilayer wiring structure, processing for forming a via hole in an insulation film such as a gate insulation film or a planarization film is required. As a method of the processing, e.g. a photolithography method using a photoresist is employed. In a case where a material itself for an insulation film has a photosensitivity, it is possible to carry out processing by a photolithography method without using a photoresist.

However, the photolithography method requires many steps such as development and washing after pattern exposure.

Accordingly, as one of new micro-fabrication techniques, attention has been drawn to a laser ablation method, wherein an insulation film is irradiated with laser light thereby to locally decompose and remove the insulation film. For example, Patent Document 2 discloses a method of irradiating an insulation film made of a polyimide with laser light to form a via hole.

### PRIOR ART DOCUMENTS

### PATENT DOCUMENTS

Patent Document 1: JP-A-2000-100936
Patent Document 2: JP-A-2003-8174

### DISCLOSURE OF INVENTION

### TECHNICAL PROBLEM

However, according to the findings of the present inventors, in the case of the above CYTOP, a film is hardly decomposed even when irradiated with laser light, and therefore it is impossible to form a via hole by means of a laser ablation method.

The present invention has been made under these circumstances, and it is an object of the present invention to provide a curable composition, a cured film of which has a low dielectric constant and a low water absorption and is processable by means of a laser ablation method; a laser processing method of a cured film obtained by curing the curable composition; and a process for producing a multilayer wiring structure by means of the laser processing method.

### SOLUTION TO PROBLEM

The present invention provides a curable composition, a coating composition, a cured film, a laser processing method and a process for producing a multilayer wiring structure, according to the following [1] to [12].
[1] A curable composition for obtaining a cured film a part of which is to be removed by irradiation with laser light, which comprises a fluorinated polyarylene prepolymer (A) having a crosslinkable functional group.
[2] The curable composition according to the above [1], wherein the content of the fluorinated polyarylene prepolymer (A) in the curable composition is from 10 to 100 mass%.
[3] The curable composition according to the above [1] or [2], which further contains a compound (B) having a number average molecular weight of from 140 to 5,000, having at least two crosslinkable functional groups and having no fluorine atoms.
[4] The curable composition according to any one of the above [1] to [3], which further contains a radical polymerization initiator (C).
[5] The curable composition according to any one of the above [1] to [4], which further contains a dye (D) for absorbing laser light for the irradiation.
[6] The curable composition according to any one of the above [1] to [5], wherein the fluorinated polyarylene prepolymer (A) is a polymer having a crosslinkable functional group and an ether bond, obtained by subjecting either one or both of a compound (Y-1) having a crosslinkable functional group and a phenolic hydroxy group and a compound (Y-2) having a crosslinkable functional group and a fluorinated aromatic ring, a fluorinated aromatic compound (Z1) represented by the following formula (1): 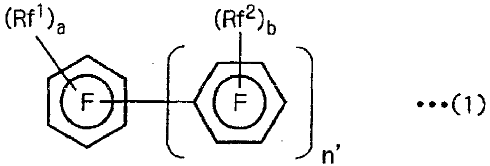 (wherein n' is an integer of from 0 to 3, each of a and b which are independent of each other, is an integer of from 0 to 3, each of Rf¹ and Rf² which may be the same or different from each other, is a fluorinated alkyl group having at most 8 carbon atoms, and F in the aromatic ring represents that hydrogen atoms of the aromatic ring are all substituted by fluorine atoms), and a compound (Z2) having at least three phenolic hydroxy groups, to a condensation reaction in the presence of a HF-removing agent.
[7] A coating composition comprising the curable composition as defined in any one of the above [1] to [6] and a solvent.
[8] A cured film obtainable by forming a coating film from the curable composition as defined in any one of the above [1] to [6] or the coating composition as defined in the above [7], removing the solvent as the case requires, and then curing the coating film by thermosetting or photocuring.
[9] A laser processing method comprising a step of irradiating the cured film as defined in the above [8] with laser light to remove a part of the film.
[10] The laser processing method according to the above [9], wherein the cured film has a thickness of from 0.1 to 100 µm.
[11] The laser processing method according to the above [9] or [10], wherein the laser light has an oscillation wavelength of from 190 to 1,100 nm.
[12] A process for producing a multilayer wiring structure, comprising a step of irradiating an insulation film made of the cured film obtained by curing the curable composition with the laser light, to form a via hole, by means of the laser processing method as defined in any one of the above [9] to [11].

### ADVANTAGEOUS EFFECTS OF INVENTION

According to the curable composition of the present invention, it is possible to provide a cured film having a low dielectric constant and a low water absorption and being processable by a laser ablation method for removing a part of the cured film by irradiation with laser light, and further the cured film is processable with good precision by means of the laser processing method of the present invention, with a small number of steps.

According to the process for producing a multilayer wiring structure of the present invention, it is possible to produce a multilayer wiring structure provided with an insulation film having a via hole formed with good precision, having a low dielectric constant and a low water absorption.

### DESCRIPTION OF EMBODIMENTS

### [Crosslinkable functional group]

The crosslinkable functional group in the present invention is a functional group which can undergo radical polymerization reaction by providing external energy, whereby a compound having the crosslinkable functional group undergoes reaction such as polymerization, crosslinking or chain extension.

In a case where the after-mentioned radical polymerization initiator (C) is contained in the curable composition of the present invention, radicals are generated from the radical polymerization initiator (C) by action of external energy, and by the radicals, the crosslinkable functional group is made to undergo polymerization reaction. Even when the radical polymerization initiator (C) is not contained therein, the crosslinkable functional group undergoes polymerization reaction by providing external energy.

In the present invention, as an external energy, heat or light is used. Further, they may be used in combination.

The crosslinkable functional group in the present invention may, for example, be a carbon-carbon unsaturated double bond which is polymerizable by radicals, a carbon-carbon unsaturated triple bond which is polymerizable by radicals, a ring which is to be opened by radicals, and groups containing them.

The above unsaturated double bond and unsaturated triple bond may be present in the inside of a molecular chain (hereinafter, also referred to as "inside olefin type") or present at a terminal (hereinafter, also referred to as "terminal olefin type"), but a terminal olefin type is preferred since its reactivity is high.

The unsaturated double bond may be an inside olefin type or a terminal olefin type, but a terminal olefin type is preferred.

The inside of a molecular chain includes a case of a part of an aliphatic ring such as cycloolefin.

The terminal olefin type crosslinkable functional group is preferably an alkenyl group having at most 4 carbon atoms or an alkynyl group having at most 4 carbon atoms.

Specifically, a vinyl group, an allyl group, an isopropenyl group, a 3-butenyl group, a methacryloyl group, a methacryloyloxy group, an acryloyl group, an acryloyloxy group, a vinyloxy group, an allyloxy group, a trifluorovinyl group, a trifluorovinyloxy group, an ethynyl group, a 1-oxocyclopenta-2,5-dien-3-yl group, a diarylhydroxymethyl group, a hydroxyfluorenyl group, a cyclobutalene ring or an oxirane ring may be mentioned.

The crosslinkable functional group in the present invention is preferably at least one member selected from the group consisting of a vinyl group, an allyl group, an ethynyl group, a vinyloxy group, an allyloxy group, an acryloyl group, an acryloyloxy group, a methacryloyl group and a methacryloyloxy group, since the reactivity is high, and a cured film having high crosslinking density can easily be obtained.

In this specification, a methacryloyl group and a methacryloyloxy group are generally referred to as "a methacryloyl(oxy) group". The same applies to "an acryloyl(oxy) group". Further, an acryloyl group and a methacryloyl group are generally referred to as "a (meth)acryloyl group". The same applies to "a (meth)acryloyloxy group". Moreover, all of such compounds are sometimes generally referred to as "a (meth)acryloyl(oxy) group".

### [Fluorinated polyarylene prepolymer (A)]

The fluorinated polyarylene prepolymer (A) in the present invention (hereinafter also referred to as "prepolymer (A)") has a polyarylene structure wherein a plurality of aromatic rings are bonded via a single bond or a linking group, and at the same time it has fluorine atoms and a crosslinkable functional group. By incorporating the prepolymer (A) into the curable composition, a cured film can exhibit a low dielectric constant.

The crosslinkable functional group of the prepolymer (A) undergoes substantially no reaction at the time of producing the prepolymer (A), and undergoes radical polymerization reaction to cause crosslinking or chain extension between molecules of the prepolymer (A), by providing an external energy. Further, in a case where the compound (B) having crosslinkable functional groups is contained in the curable composition, it is considered that it is also reacted with the crosslinkable functional groups of the compound (B) and integrated with them to produce a cured film.

The crosslinkable functional group in the prepolymer (A) is particularly preferably a vinyl group or an ethynyl group from the viewpoint that the reactivity at the time of producing the prepolymer (A) is low and that the reactivity at the time of providing an external energy is high. Further, the prepolymer (A) may have two or more different crosslinkable functional groups in one molecule.

The linking group in the polyarylene structure may, for example, be an ether bond (-O-), a sulfide bond (-S-), a carbonyl group (-CO-) or a sulfonyl group (-SO₂-).

In the prepolymer (A), especially, a polymer having a structure in which aromatic rings are bonded by a liking group containing an ether bond (-O-) is referred to as "a fluorinated polyarylene ether prepolymer". The fluorinated polyarylene ether prepolymer is preferred in that it has an etheric oxygen atom, whereby the molecular structure has flexibility, and the flexibility of a cured film is good.

It is preferred that the prepolymer (A) contains a fluorinated polyarylene ether prepolymer, and it is particularly preferred that the prepolymer (A) consists solely of the fluorinated polyarylene ether prepolymer.

As a specific example of the linking group containing the ether bond, an ether bond (-O-) made solely of an etheric oxygen atom or an alkylene group containing an etheric oxygen atom in a carbon chain may, for example, be mentioned.

The prepolymer (A) has fluorine atoms. As it has fluorine atoms, the dielectric constant and the dielectric loss of a cured film tend to be low, such being desirable as a material to form an insulation film. When the dielectric constant and dielectric loss of an insulation film are low, it is possible to prevent delay of a signal propagation velocity in a multilayer wiring board produced by using the insulation film and to obtain a device excellent in electrical properties.

Further, as it has fluorine atoms, the water absorption of the cured film becomes low, whereby it is possible to prevent a change in the bonded state at the bonded electrodes and wiring portions therearound, or it is possible to prevent modification (such as rusting) of metals, and it presents a substantial effect to improve the reliability of a device.

As a specific example of the prepolymer (A) in the present invention, a polymer (hereinafter, also referred to as "prepolymer (A1)") having a crosslinkable functional group and an ether bond, obtained by subjecting either one or both of a compound (Y-1) having a crosslinkable functional group and a phenolic hydroxy group and a compound (Y-2) having a crosslinkable functional group and a fluorinated aromatic ring, a fluorinated aromatic compound (Z1) represented by the following formula (1), and a compound (Z2) having at least three phenolic hydroxy groups, to a condensation reaction in the presence of a HF-removing agent, may be mentioned.

In the prepolymer (A1), by using the compound (Z2) having at least three phenolic hydroxy groups, it is possible to introduce branched structures to the polymer chain to make the molecular structure three dimensional thereby to increase the free volume of the polymer, whereby low densification i.e. a low dielectric constant can be accomplished.

Further, usually, a linear chain polymer having aromatic rings is likely to undergo orientation of molecules due to stacking of the aromatic rings, but with the cured product of the present invention, orientation of molecules is suppressed by the introduction of branched structures, and consequently, the birefringence will be small. 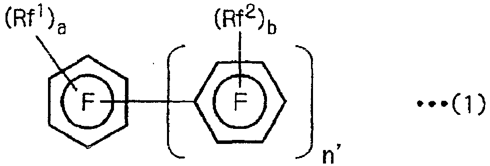 wherein n' is an integer of from 0 to 3, each of a and b which are independent of each other, is an integer of from 0 to 3, each of Rf¹ and Rf² which may be the same or different from each other, is a fluorinated alkyl group having at most 8 carbon atoms, and F in the aromatic ring represents that hydrogen atoms of the aromatic ring are all substituted by fluorine atoms.

The prepolymer (A1) may be produced by either or both of the following methods (i) and (ii).
(i) A method of subjecting the fluorinated aromatic compound (Z1), the compound (Z2) and the compound (Y-1)to a condensation reaction in the presence of a HF-removing agent.
(ii) A method of subjecting the fluorinated aromatic compound (Z1), the compound (Z2) and the compound (Y-2) to a condensation reaction in the presence of a HF-removing agent.

Further, in a case where the prepolymer (A1) is produced by both of the above (i) and (ii), the fluorinated aromatic compound (Z1) , the compound (Z2), the compound (Y-1) and the compound (Y-2) are subjected to a condensation reaction in the presence of a HF-removing agent.

Moreover, in each of the above methods (i) and (ii), the condensation reaction may be a single step reaction or a multi-step reaction. Further, among the reaction raw materials, a specific compound may be reacted preferentially in advance, and subsequently the other compounds may be reacted.

In the case of the multi-step condensation reaction, an intermediate product obtained in the middle of the reaction may be separated from the reaction system, purified, and then used for a subsequent reaction (condensation reaction). In the reaction site, the raw material compounds may be charged all together, continuously or intermittently.

In the above process for producing the prepolymer (A1), the condensation reaction proceeds as represented by the following formula (2) in which an ether bond is formed by e.g. a reaction mechanism wherein a phenoxy group derived from a phenolic hydroxy group attacks the carbon atom to which a fluorine atom is bonded of the fluorinated aromatic compound (Z1), and then the fluorine atom is eliminated.

Further, in a case where the compound (Z2) and/or (Y-1) has two phenolic hydroxy groups which are in an ortho position to each other, there is a possibility that a dioxine skeleton is formed by the reaction represented by the following formula (3) by e.g. a similar reaction mechanism.

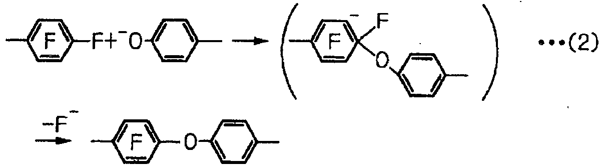

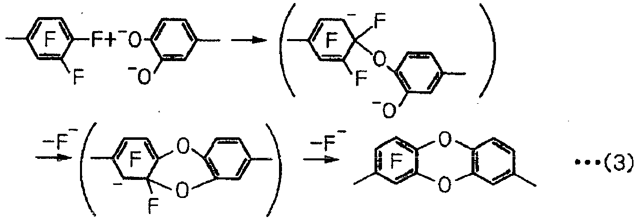

As the compound (Y-1) to be used in the production process (i), a compound (Y-1-1) having one phenolic hydroxy group and a compound (Y-1-2) having two phenolic hydroxy groups, are preferred.

Specific examples of the compound (Y-1-1) include a phenol having a reactive double bond such as 4-hydroxystyrene; and an ethynylphenol such as 3-ethynylphenol, 4-phenylethynyl phenol and 4-(4-fluorophenyl)ethynylphenol. They may be used alone or in combination as a mixture of two or more of them. Particularly preferred is an aromatic compound having a vinyl group or an ethynyl group as the crosslinkable functional group.

Specific examples of the compound (Y-1-2) include a bis(phenylethynyl)dihydroxybiphenyl such as 2,2'-bis(phenylethynyl)-5,5'-dihydroxybiphenyl and 2,2'-bis(phenylethynyl)-4,4'-dihydroxybiphenyl; and a dihydroxydiphenylacetylene such as 4,4'-dihydroxytolane and 3,3'-dihydroxytolane. They may be used alone or in combination as a mixture of two or more of them.

As the compound (Y-2) to be used in the production process (ii), a compound having a crosslinkable functional group and a perfluoroaromatic ring such as perfluorophenyl or perfluorobiphenyl, is preferred. Its specific examples include a fluorinated aryl having a reactive double bond, such as pentafluorostyrene, pentafluorobenzyl acrylate, pentafluorobenzyl methacrylate, pentafluorophenyl acrylate, pentafluorophenyl methacrylate, perfluorostyrene, pentafluorophenyl trifluorovinyl ether and 3-(pentafluorophenyl)pentafluoropropene-1; a fluorinated aryl having a cyano group such as pentafluorobenzonitrile; a fluorinated arylacetylene such as pentafluorophenylacetylene and nonafluorobiphenylacetylene; and a fluorinated diarylacetylene such as phenylethynylpentafluorobenzene, phenylethynylnonafluorobiphenyl and decafluorotolane. They may be used alone or in combination as a mixture of two or more of them. As the compound (Y-2), a fluorinated aryl having a double bond or a fluorinated arylacetylene having a triple bond is preferred since the crosslinking reaction thereby proceeds at a relatively low temperature, and the heat resistance of a prepolymer cured product thereby obtained becomes high.

As the HF-removing agent to be used for the production of the prepolymer (A1), a basic compound is preferred, and an alkali metal carbonate, hydrogen carbonate or hydroxide is particularly preferred. Specific examples include sodium carbonate, potassium carbonate, sodium hydrogencarbonate, potassium hydrogencarbonate, sodium hydroxide and potassium hydroxide.

With respect to the amount of the HF-removing agent to be used, in the production process (i), it is required to be an amount of at least equimolar, preferably from 1.1 to 3 times by the molar ratio to the total number of moles of phenolic hydroxy groups in the compound (Z2) and the compound (Y-1). In the production process (ii), it is required to be an amount of at least equimolar, preferably from 1.1 to 3 times by the molar ratio to the number of moles of phenolic hydroxy groups in the compound (Z2).

In the production processes (i) and (ii), the condensation reaction is preferably carried out in a polar solvent. The polar solvent is preferably an aprotic polar solvent such as an amide such as N,N-dimethylacetamide, N,N-dimethylformamide or N-methylpyrrolidone; a sulfoxide such as dimethylsulfoxide; a sulfone such as sulfolane; or an ether such as diethyl ether, tetrahydrofuran, dioxane, diethylene glycol dimethyl ether, diethylene glycol diethyl ether or triethylene glycol dimethyl ether.

To the polar solvent, toluene, xylene, benzene, tetrahydrofuran, benzotrifluoride, xylenehexafluoride or the like may be incorporated within a range not to deteriorate the solubility of the prepolymer to be formed and not to adversely affect the condensation reaction. By such incorporation, the polarity (the dielectric constant) of the solvent may be changed to control the reaction rate.

The condensation reaction conditions are preferably from 10 to 200°C for from 1 to 80 hours, more preferably from 20 to 180°C for from 2 to 60 hours, most preferably from 50 to 160°C for from 3 to 24 hours.

In the production process (i), the amount of the compound (Z2) to be used is preferably from 0.1 to 1 time, particularly preferably from 0.3 to 0.6 time in a molar ratio to the fluorinated aromatic compound (Z1). The amount of the compound (Y-1) to be used is preferably from 0.1 to 2 times, particularly preferably from 0.2 to 1.5 times in a molar ratio to the fluorinated aromatic compound (Z1).

In the production process (ii), the amount of the compound (Z2) to be used is preferably from 0.5 to 2 times, particularly preferably from 0.6 to 1.5 times in a molar ratio to the fluorinated aromatic compound (Z1). The amount of the compound (Y-2) to be used is preferably from 0.1 to 2 times, particularly preferably from 0.2 to 1.5 times in a molar ratio to the fluorinated aromatic compound (Z1).

When the respective amounts are in such ranges, the resulting prepolymer will have a low dielectric constant and high heat resistance, such being desirable.

As the production process of the prepolymer (A1), the production process (i) or (ii) may suitably be selected depending upon the physical properties such as the heat resistance, relative dielectric constant, birefringence, and flexibility, of a cured product obtainable after the curing. For example, in a case where the production process (ii) is used, the relative dielectric constant and birefringence values of a cured product obtainable by curing the prepolymer (A1) thus produced usually tend to be low. That is, to obtain a cured product having low relative permittivity and birefringence values, it is preferred to produce the prepolymer (A1) by the production process (ii).

After the condensation reaction or after formed into a solution, the prepolymer (A1) is purified by a method such as neutralization, reprecipitation, extraction or filtration.

The purification is preferably carried out in a state where the polar solvent preferably used during the production, is present, or in a state as dissolved or dispersed in the after-mentioned solvent, since the efficiency is thereby good.

In an application as an insulation film for electronic devices or an insulation film for multilayer wiring boards, a metal such as potassium or sodium as a condensation reaction catalyst and free halogen atoms are likely to cause operation failure of a transistor or corrosion of wiring, and accordingly, it is preferred to sufficiently carry out the purification.

Suitable examples of the prepolymer (A1) include a polymer obtainable by reacting a fluorinated aromatic compound such as perfluoro(1,3,5-triphenylbenzene) or perfluorobiphenyl;
a phenol compound such as 1,3,5-trihydroxybenzene or 1,1,1-tris(4-hydroxyphenyl)ethane; and
a crosslinkable functional group-containing aromatic compound such as pentafluorostyrene, acetoxystyrene, chloromethylstyrene or pentafluorophenylacetylene, in the presence of a hydrogen halide removing agent such as potassium carbonate.

The number average molecular weight (Mn) of the prepolymer (A) is preferably from 1,000 to 100,000, more preferably from 5,000 to 50,000, particularly preferably from 5,000 to 20,000. When the number average molecular weight (Mn) is at least the lower limit value of the above range, the flexibility of the cured film does not tend to decrease, and when it is at most the upper limit value of the above range, a curable composition can readily be purified.

In this specification, the number average molecular weight (Mn) is a molecular weight calculated as polystyrene obtainable by measurement by gel permeation chromatography employing a calibration curved prepared by using a standard polystyrene sample having a known molecular weight.

### [Curable composition]

The curable composition of the present invention is one used as a curable composition for obtaining a cured film a part of which is to be removed by irradiation with laser light. That is, it is used for a processing method wherein a cured film obtained by curing the curable composition is irradiated with laser light thereby to decompose and remove a part of the cured film, that is a laser ablation processing method.

The curable composition in the present invention contains the prepolymer (A). As the case requires, it may contain the after-mentioned compound (B), radical polymerization initiator (C), dye (D) and other additives.

The content of the prepolymer (A) in the curable composition is preferably from 10 to 100 mass%, particularly preferably from 20 to 100 mass%.

### (Compound (B))

It is preferred that the curable composition of the present invention contains a compound (B) having a number average molecular weight (Mn) of from 140 to 5,000, having at least two crosslinkable functional groups and having no fluorine atoms, in addition to the prepolymer (A). By the curable composition containing the compound (B), the curability at a low temperature is improved. Further, the hardness and the solvent resistance of a cured film are improved.

Further, in a case where the compound (B) contains a liquid compound, the compound (B) functions as a solvent, whereby the curable composition can be applied. The lower the viscosity of the compound (B) becomes, and further the larger the amount of the compound (B) to be blended becomes, the lower the viscosity of the curable composition of the present invention becomes, whereby the coatability is improved.

The number average molecular weight (Mn) of the compound (B) is preferably from 200 to 3,000, particularly preferably from 250 to 2,500. When it is at least the lower limit value of the above range, the compound (B) is less likely to be volatilized by heating. When it is at most the upper limit value of the above range, the viscosity of the compound (B) can be suppressed to be low, and therefore a uniform curable composition can readily be obtained when the compound (B) is mixed with the prepolymer (A).

Since the compound (B) has at least two crosslinkable functional groups, it is capable of intermolecular crosslinking. The compound (B) has preferably from 2 to 20, particularly preferably from 2 to 8, crosslinkable functional groups.

The crosslinkable functional groups of the compound (B) are preferably groups being reactive in the same step as in the step in which the crosslinkable functional group of the prepolymer (A) undergoes radical polymerization reaction.

The crosslinkable functional groups of the compound (B) are reacted with each other to induce crosslinking or chain extension. Further, it is considered that they are reacted with the crosslinkable functional group of the prepolymer (A), and integrated to form a cured film. The crosslinkable functional group of the compound (B) is preferably a (meth)acryloyl(oxy) group. From the viewpoint of high reactivity and availability, a (meth)acryloyloxy group is more preferred, and from the viewpoint of higher reactivity, an acryloyl group and an acryloyloxy group are particularly preferred. Further, two or more different crosslinkable functional groups may be present in one molecule. The crosslinkable functional groups in the prepolymer (A) and the compound (B) coexisting in the curable composition may be the same or different.

Specific examples of the compound (B) include dipentaerythritol triacrylate triundecylate, dipentaerythritol pentaacrylate monoundecylate, ethoxylated isocyanuric acid triacrylate, ε-caprolactone-modified tris-(2-acryloxyethyl) isocyanurate, 9,9-bis[4-(2-acryloyloxyethoxy)phenyl]fluorene, polyethylene glycol diacrylate, polyethylene glycol dimethacrylate, polypropylene glycol diacrylate, polypropylene glycol dimethacrylate, ethoxylated bisphenol A diacrylate, ethoxylated bisphenol A dimethacrylate, propoxylated bisphenol A diacrylate, propoxylated bisphenol A dimethacrylate, 1,10-decanediol diacrylate, 1,6-hexanediol diacrylate, 1,6-hexanediol dimethacrylate, 1,4-butanediol dimethacrylate, 1,3-butanediol dimethacrylate, hydroxypivalic acid neopentyl glycol diacrylate, 1,9-nonanediol diacrylate, 1,9-nonanediol dimethacrylate, neopentyl glycol diacrylate, neopentyl glycol dimethacrylate, pentaerythritol triacrylate, trimethylolpropane triacrylate, ethoxylated trimethylolpropane triacrylate, propoxylated trimethylolpropane triacrylate, triallyl cyanurate, triallyl isocyanurate, trimethallyl isocyanurate, 1,4-butanediol divinyl ether, 1,9-nonanediol divinyl ether, cyclohexane dimethanol divinyl ether, triethylene glycol divinyl ether, trimethylolpropane trivinyl ether, pentaerythritol tetravinyl ether, 2-(2-vinyloxyethoxy)ethyl acrylate, 2-(2-vinyloxyethoxy)ethyl methacrylate, trimethylolpropane diallyl ether, pentaerythritol triallyl ether, dipentaerythritol hexaacrylate, pentaerythritol tetraacrylate, an ethoxylated pentaerythritol tetraacrylate represented by the following formula (4), a propoxylated pentaerythritol tetraacrylate represented by the following formula (5), ditrimethylolpropane tetraacrylate, tricyclodecane dimethanol diacrylate, tricyclodecane dimethanol methacrylate, and a compound represented by the following formula (6).

Further, polyester acrylates (a compound obtained by modifying both terminals of a condensate of a dihydric alcohol and a dibasic acid with acrylic acid: tradename Aronix (M-6100, M-6200, M-6250 or M-6500), manufactured by TOAGOSEI CO., LTD.; and a compound obtained by modifying terminal hydroxy groups of a condensate of a polyhydric alcohol and a polybasic acid, with acrylic acid: tradename Aronix (M-7100, M-7300K, M-8030, M-8060, M-8100, M-8530, M-8560 or M-9050) manufactured by TOAGOSEI CO., LTD.) may also be used. These products are available from commercial products. 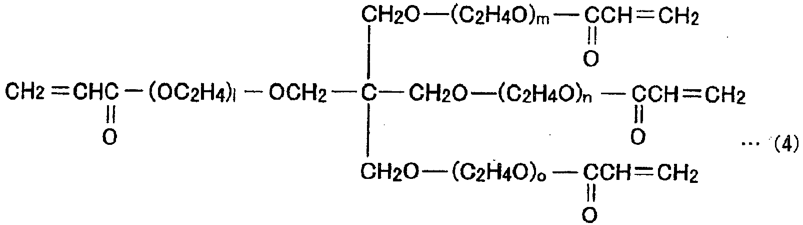 (In the formula, l+m+n+o is from 4 to 35.) 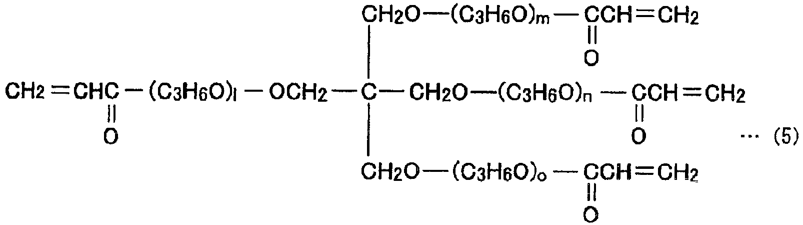 (In the formula, l+m+n+o is about 4.) 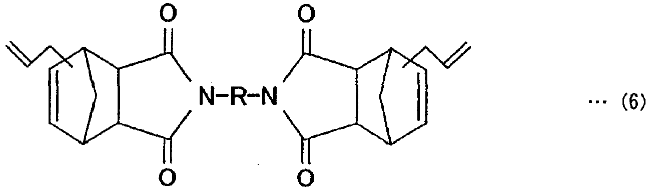 (In the formula, R is

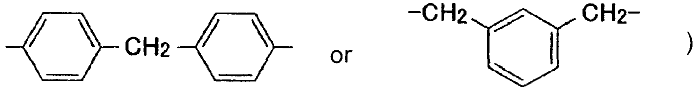

As the compound (B) to be used in the present invention, ethoxylated isocyanuric acid triacrylate, 1,10-decanediol diacrylate, 1,9-nonanediol diacrylate, 1,9-nonanediol dimethacrylate, trimethylolpropane triacrylate, dipentaerythritol hexaacrylate, pentaerythritol tetraacrylate, ditrimethylolpropane tetraacrylate or tricyclodecane dimethanol diacrylate is particularly preferred from the viewpoint of availability and reactivity.

In a case where the compound (B) is incorporated into the curable composition of the present invention, its content is preferably from 10 to 80 parts by mass, more preferably from 15 to 70 parts by mass, particularly preferably from 20 to 60 parts by mass based on the total amount (100 parts by mass) of the prepolymer (A) and the compound (B). When the proportion of the compound (B) is at least the lower limit value of the above range, it is possible to readily obtain a sufficient effect by incorporating the compound (B). Further, when the proportion of the compound (B) is at most the upper limit value of the above range, the dielectric constant of a cured film becomes sufficiently low.

### (Radial polymerization initiator (C))

The curable composition of the present invention preferably contains a radical polymerization initiator (C). By containing the radical polymerization initiator (C), a cured film can efficiently be produced, and the solvent resistance of the cured film is improved.

The curable composition of the present invention may be a heat-curable composition using heat or a photocurable composition using light (actinic rays), as the external energy for curing. From the viewpoint that curing of the curable composition readily proceeds, a heat-curable composition is preferred. From the viewpoint of low burden on a substrate, a photocurable composition is preferred.

### <Thermal polymerization initiator (C1)>

In the case of a heat curable composition, as the radical polymerization initiator (C), a thermal polymerization initiator (C1) which generates radicals by heat is used. If the reaction temperature is too low, it is impossible to secure the stability during the storage of the compounds having crosslinkable functional groups or the composition containing it, and therefore the reaction temperature is preferably at least 40°C, more preferably at least 60°C, particularly preferably at least 70°C. The upper limit of the reaction temperature is at most the upper limit of a heat temperature acceptable in the step of production of the cured film, for example at most a heat resistant temperature of a substrate. Since a lower reaction temperature is applicable to a lower temperature process, the reaction temperature is preferably e.g. at most 250°C, Particularly preferably at most 200°C.

Such a thermal polymerization initiator (C1) may be a known initiator. Specific examples include azobisisobutyronitrile, benzoyl peroxide, tert-butylhydroperoxide, cumene hydroperoxide, di-tert-butyl peroxide and dicumyl peroxide. They may be used alone or in combination of two or more of them.

From the viewpoint of the decomposition temperature, azobisisobutyronitrile or benzoyl peroxide is preferred.

In a case where the curable composition of the present invention contains the thermal polymerization initiator (C1), its content is preferably from 1 to 20 parts by mass, particularly preferably from 5 to 15 parts by mass based on the total amount (100 parts by mass) of the prepolymer (A) and the compound (B). When it is at least the lower limit value of the above range, an effect of improving curability at the time of curing at a low temperature is sufficiently obtained, and the solvent resistance of a cured film is sufficiently improved. When it is at most the upper limit value of the above range, the storage stability of the curable composition becomes good.

### <Photopolymerization initiator (C2)>

In the case of a photocurable composition, as the radical polymerization initiator (C), a photopolymerization initiator (C2) which generates radicals by light (actinic rays) is used. A wavelength of light to be applied for curing the curable composition is not particularly limited, but ultraviolet ray is suitably used.

Such a photopolymerization initiator (C2) may be one known for a photocurable composition. Specific examples of the photopolymerization initiator (C2) having sensitivity in an ultraviolet ray region include an oxime ester derivative such as 1,2-octanedione, 1-[4-(phenylthio)-, 2-(o-benzoyloxime)] (for example, tradename: IRGACURE OXE01), and ethanone, 1-[9-ethyl-6-(2-methylbenzoyl)-9H-carbazol-3-yl]-, 1-(o-acetyloxime) (for example, tradename: IRGACURE OXE02): an α-aminoalkylphenone type compound such as IRGACURE 369 (tradename) and IRGACURE 907 (tradename); and an acylphosphine oxide type compound such as DAROCUR TPO (tradename) (each manufactured by Ciba Specialty Chemicals Corporation).

From the viewpoint of good reactivity of radicals to be generated, IRGACURE OXE01 and IRGACURE OXE02 are preferred.

In a case where the photopolymerization initiator (C2) is contained in the curable composition of the present invention, its content is preferably from 1 to 20 parts by mass, particularly preferably from 3 to 15 parts by mass based on the total amount (100 parts by mass) of the prepolymer (A) and the compound (B). When such a content is at least the lower limit value of the above range, an effect of improving curability at the time of curing at a low temperature can be sufficiently obtained, and the solvent resistance of a cured film is sufficiently improved. When it is at most the upper limit value of the above range, the storage stability of the curable composition becomes good.

### (Dye (D))

The curable composition of the present invention preferably contains a dye (D) absorbing laser light applied to a cured film. By containing the dye (D), an absorption rate of irradiation energy in the cured film improves, whereby laser processing of the cured film with lower irradiation energy becomes possible. Further, even in the case of a wavelength with little absorption by the prepolymer (A), by the dye (D) having absorbing properties in the wavelength, it is possible to suitably carry out laser processing using laser light at the wavelength.

The dye (D) may be a compound having absorbing properties of laser light, such as a benzophenone type compound, a benzotriazole type compound, a benzoate type compound or a triazine type compound.

The dye (D) may suitably be selected depending upon a wavelength of laser light to be applied. For example, in a case where an ultraviolet laser light is used as laser light, as the dye (D), a known compound as a ultraviolet ray absorber may be used.

In a case where a cured film obtainable by curing the curable composition of the present invention is used for a multilayer wiring structure, as the dye (D), a transparent compound with little absorption in a visible light region is preferred.

The molecular weight of the dye (D) is not particularly limited, but is preferably at least 200, particularly preferably at least 400 in view of less volatility. The upper limit of the molecular weight is preferably at most 2,000, particularly preferably at most 1,000 from the viewpoint of compatibility with a resin.

The dye (D) preferably has a polar group from the viewpoint that good compatibility with the prepolymer (A) can readily be obtained. The polar group may, for example, be a carbonyl group or an alkoxy group. Further, the dye (D) preferably has a crosslinkable functional group since the dye (D) can readily be fixed by crosslinking reaction with the prepolymer (A) or the compound (B).

Such a dye (D) may, for example, be a benzophenone type compound, a benzotriazole type compound, a benzoate type compound or a triazine type compound, which has a polar group and/or a crosslinkable functional group.

The dye (D) having a crosslinkable functional group may be available from a commercial product, or synthesized by reacting a compound (d1) having a reactive functional group which can introduce a crosslinkable functional group with a compound (d2) having a crosslinkable functional group and being reactive with the reactive functional group, by a known method.

The reactive functional group may, for example, be a hydroxy group, a mercapto group, an amino group or a carboxy group. For example, in a case where the reactive functional group of the compound (d1) is a hydroxy group, it is possible to obtain a compound having a crosslinkable functional group introduced to the terminal of the compound (d1), by a method of reacting the compound (d1) with the compound (d2) which is an isocyanate compound having a crosslinkable functional group; a method of reacting the compound (d1) with the compound (d2) which is a carboxylic acid halide having a crosslinkable functional group, under basic conditions; or a method of reacting the compound (d1) with the compound (d2) which is a halogenated alkyl having a crosslinkable functional group.

The compound (d1) having a reactive functional group which can introduce a crosslinkable functional group may be obtainable from a commercial product, and it may also be prepared by a know method. The dye (D) having a crosslinkable functional group may be obtained by preparing the compound (d1) and further reacting it with the compound (d2).

Further, it is possible to obtain the same effect as in the case of incorporating the dye (D) having a crosslinkable functional group to the curable composition, by reacting the compound (d1) and the compound (d2) in the process of incorporating the compound (d1) and the compound (d2) respectively to the curable composition to form a cured film of the curable composition. In such a case, the entirety of the compound (D1) and the compound (d2) will be referred to as the dye (D).

As examples of commercially available dye (D), the following may be mentioned.

TINUVIN P (manufactured by BASF), TINUVIN PS (manufactured by BASF), TINUVIN 99-2 (manufactured by BASF)), TINUVIN 109 (manufactured by BASF), TINUVIN 120 (manufactured by BASF), TINUVIN 213 (manufactured by BASF), TINUVIN 234 (manufactured by BASF), TINUVIN 326 (manufactured by BASF), TINUVIN 328 (manufactured by BASF), TINUVIN 329 (manufactured by BASF), TINUVIN 384-2 (manufactured by BASF), TINUVIN 400 (manufactured by BASF), TINUVIN 405 (manufactured by BASF), TINUVIN 460 (manufactured by BASF), TINUVIN 477DW (manufactured by BASF), TINUVIN 479 (manufactured by BASF), TINUVIN 571 (manufactured by BASF), TINUVIN 900 (manufactured by BASF), TINUVIN 928 (manufactured by BASF), TINUVIN 1130 (manufactured by BASF), TINUVIN 1577 (manufactured by BASF), TINUVIN 5236 (manufactured by BASF), CHIMASSORB 81 (manufactured by BASF), ADEKASTAB LA series (manufactured by ADEKA CORPORATION), 2,4-dihydroxybenzophenone, 2-hydroxy-4-octyloxybenzophenone, 2-(2H-benzotriazol-2-yl)-4-t-butylphenol, 2-(2'-hydroxy-5'-methylphenyl)benzotriazole, 2-(2'-hydroxy-5'-octylphenyl)benzotriazole, 2-(2'-hydroxy-3',5'-di-t-amylphenyl)benzotriazole, 2-[2'-hydroxy-3,5-di(1,1-dimethylbenzyl)phenyl]-2H-benzotriazole, 2,2'-methylenebis[6-(2H-benzotriazole-2-yl)-4-(1,1,3,3-tetramethylbutyl)phenol], 2-(2'-hydroxy-5'-methylphenyl)benzotriazole, 2,4-di-t-butylphenyl-3,5-di-t-butyl-4-hydroxybenzoate, 2-[4,6-bis(2,4-dimethylphenyl)-1,3,5-tirazin-2-yl]-5-octyloxyphenol and 2-(4,6-diphenyl-1,3,5-triazin-2-yl)-5-hexyloxyphenol.

Further, the dye (D) having a hydroxy group is obtained from a commercial product, the hydroxy group is converted to a (meth)acryloyl group, and such a compound may be used as the dye (D) having a crosslinkable functional group.

In a case where the curable composition of the present invention contains the dye (D), its content is preferably from 0.01 to 20 parts by mass, particularly preferably from 0.1 to 10 parts by mass based on the total amount (100 parts by mass) of the prepolymer (A) and the compound (B). When the amount is at least the lower limit value of the above range, an effect of adding the dye (D) can efficiently be obtained, and when it is at most the upper limit value of the above range, the electrical characteristic is not impaired.

### (Other additives)

To the curable composition of the present invention, an additive selected from various additives well known in the field of coating, for example, stabilizers such as an antioxidant, a thermal polymerisation preventing agent, etc.; surfactants such as a leveling agent, a defoaming agent, a precipitation-preventing agent, a dispersant, etc.; plasticizers; and thickeners, may be incorporated, as the case requires, so as not to impair the effect of the present invention.

Further, in a case where the cured film is a member which functions in a final product without being removed during the production process, for example, an interlayer dielectric film, an adhesion-improving agent such as a silane coupling agent may be incorporated to the curable composition. It is preferred to incorporate an adhesion-improving agent to the curable composition, since the adhesion between the cured film of the curable composition and a layer adjacent thereto will be improved. Further, it is possible to improve adhesion also by a method of preliminarily applying an adhesion-improving agent to the layer adjacent thereto.

In a case where an additive is contained in the curable composition of the present invention, its content is preferably from 0.0001 to 30 parts by mass, more preferably from 0.0001 to 20 parts by mass, particularly preferably from 0.0001 to 10 parts by mass, based on the total amount (100 parts by mass) of the prepolymer (A) and the compound (B).

### (Preferred combination of curable composition)

Combination 1: A curable composition comprising the following prepolymer (A), compound (B) and thermal polymerization initiator (C1).
Prepolymer (A): A prepolymer made of perfluorobiphenyl, 1,3,5-trihydroxybenzene and acetoxystyrene. The amount of the prepolymer (A) is from 40 to 90 parts by mass based on the total amount (100 parts by mass) of the prepolymer (A) and the compound (B).
Compound (B): At least one member selected from the group consisting of ethoxylated isocyanuric acid triacrylate, ε-caprolactone-modified tris-(2-acryloxyethyl) isocyanurate, 1,10-decanediol diacrylate, 1,9-nonanediol diacrylate, 1,9-nonanediol dimethacrylate, trimethylolpropane triacrylate, dipentaerythritol hexaacrylate, pentaerythritol tetraacrylate, ditrimethylolpropane tetraacrylate and tricyclodecanedimethanol diacrylate. The amount of the compound (B) is from 10 to 60 parts by mass based on the total amount (100 parts by mass) of the prepolymer (A) and the compound (B).
Thermal polymerization initiator (C1): At least one member selected from the group consisting of benzoyl peroxide and 2,2'-azobisisobutyronitrile. The amount of the thermal polymerization initiator (C1) is from 3 to 20 parts by mass based on the total amount (100 parts by mass) of the prepolymer (A) and the compound (B).
Combination 2: A curable composition comprising the following prepolymer (A), compound (B) and photopolymerization initiator (C2).
Prepolymer (A): A prepolymer made of perfluorobiphenyl, 1,3,5-trihydroxybenzene and acetoxystyrene. The amount of the prepolymer (A) is from 40 to 90 parts by mass based on the total amount (100 parts by mass) of the prepolymer (A) and the compound (B).
Compound (B): At least one member selected from the group consisting of ethoxylated isocyanuric acid triacrylate, ε-caprolactone-modified tris-(2-acryloxyethyl) isocyanurate, 1,10-decanediol diacrylate, 1,9-nonanediol diacrylate, 1,9-nonanediol dimethacrylate, trimethylolpropane triacrylate, dipentaerythritol hexaacrylate, pentaerythritol tetraacrylate, ditrimethylolpropane tetraacrylate and tricyclodecanedimethanol diacrylate. The amount of the compound (B) is from 10 to 60 parts by mass based on the total amount (100 parts by mass) of the prepolymer (A) and the compound (B).
Photopolymerization initiator (C2): At least one member selected from the group consisting of IRGACURE OXE01 (manufactured by BASF), IRGACURE OXE02 (manufactured by BASF), IRGACURE 369 (manufactured by BASF), IRGACURE 907 (manufactured by BASF) and DAROCUR TPO (manufactured by BASF). The amount of the photopolymerization initiator (C2) is from 3 to 20 parts by mass based on the total amount (100 parts by mass) of the prepolymer (A) and the compound (B).
Combination 3: A curable composition containing a dye (D) in addition to the same prepolymer (A), compound (B) and thermal polymerization initiator (C1) as in the above combination 1.
Dye (D): At least one member selected from the group consisting of a benzophenone type compound, a benzotriazole type compound, a benzoate type compound and a triazine type compound. A curable composition containing the dye (D) in an amount of from 0.01 to 20 parts by mass based on the total amount (100 parts by mass) of the prepolymer (A) and the compound (B).
Combination 4: A curable composition containing a dye (D) in addition to the same prepolymer (A), compound (B) and photopolymerization initiator (C2) as in the above combination 2.
Dye (D): At least one member selected from the group consisting of a benzophenone type compound, a benzotriazole compound, a benzoate type compound and a triazine type compound. A curable composition containing the dye (D) in an amount of from 0.01 to 20 parts by mass based on the total amount (100 parts by mass) of the prepolymer (A) and the compound (B).

### [Coating composition]

The coating composition of the present invention contains the above curable composition and a solvent. The coating composition is applied on a substrate, and then the solvent is evaporated and removed. Accordingly, it is necessary that the solvent has a boiling point lower than the component other than the solvent in the curable composition. Among the above components (A) to (D), a compound having the lowest boiling point is usually the compound (B), and therefore in a case where the curable composition contains the compound (B), a solvent having a boiling point lower than that of the compound (B) is used. In other words, as the compound (B), it is preferred to use a compound having a boiling point sufficiently higher than that of a solvent to be used.

As the solvent, a known solvent may be used. A ketone type solvent, an ester type solvent, an ether type solvent, an amide type solvent or an aromatic type solvent may, for example, be mentioned, and specific examples include propylene glycol monomethyl ether acetate (hereinafter also referred to as "PGMEA"), mesitylene, N,N-dimethylacetamide, cyclohexanone and tetrahydrofuran.

The solvent may be used alone or in combination as a mixture of two or more of them.

The total content of the prepolymer (A) and the compound (B) in the coating composition is preferably from 1 to 60 mass%, particularly preferably from 1 to 50 mass% to the coating composition.

The content of the solvent in the coating composition is preferably from 100 to 5,000 parts by mass, particularly preferably from 100 to 3,000 parts by mass based on the total amount (100 parts by mass) of the prepolymer (A) and the compound (B).

### (Preferred combination of coating composition)

As the coating composition of the present invention, the following combinations are preferred.

Combination 5: A coating composition comprising the above preferred combination 1 of the curable composition and the following solvent.

Solvent: At least one member selected from the group consisting of PGMEA and cyclohexanone. The total content of the prepolymer (A) and the compound (B) is from 1 to 60 mass% to the coating composition.

Combination 6: A coating composition comprising the above preferred combination 2 of the curable composition and the above solvent in the preferred combination 5 of the coating composition.

### [Method of forming cured film]

A method of forming a cured film by curing the curable composition of the present invention is preferably a method of applying the curable composition or the coating composition on a substrate to form a coating film, removing the solvent as the case requires, and then curing the coating film by thermosetting or photocuring. A cured film of the curable composition may be directly formed on a substrate, or an optional layer may be formed on a substrate, and then a cured film of the curable composition is formed thereon.

A material for the substrate is not particularly limited, and plastic, glass or silicon may, for example, be mentioned. When plastic such as polycarbonate, polyethylene terephthalate, polyethylene naphthalate, polyethersulfone or polyimide is used, it is preferred since mechanical flexibility is excellent.

The thickness of a cured film is not particularly limited, and can be properly set depending on the application. For example, the thickness is preferably from about 0.1 to 100 µm, particularly preferably from 0.2 to 50 µm.

The method of applying the curable composition or the coating composition on a substrate is not particularly limited so long as it is possible to form a uniform coating film. For example, a spin coating method, a wipe coating method, a spray coating method, a squeegee coating method, a dip coating method, a die coating method, an ink jetting method, a flow coating method, a roll coating method, a casting method, a slit coating method, a screw printing method, a Langmuir-Blodgett method or a gravure coating method may be employed. From the viewpoint of productivity, a spin coating method, an ink jetting method or a slit coating method is particularly preferred.

As a method of removing the solvent in the coating film, a known method is mentioned, and a method by heating, a method by reducing pressure or a method by heating and reducing pressure may, for example, be mentioned. From the viewpoint that a defect is less likely to occur in the coating film, a method by heating is preferred. A heating temperature is preferably from 30 to 200°C, particularly preferably from 40 to 150°C.

In a case where the curing is carried out by thermosetting, the curable composition or the coating composition is applied on a substrate to form a coating film, a heating step (prebaking) for the purpose of removing the solvent is carried out as the case requires, and further a heating step (curing step) is carried out to obtain a cured film. In the case of thermosetting, the heating step (curing step) for curing may also function as the heating step for removing the solvent.

A heating temperature of the heating step (prebaking) is preferably from 40 to 200°C, particularly preferably from 60 to 200°C.

A heating temperature of the heating step (curing step) is preferably from 100 to 200°C, particularly preferably from 120 to 200°C.

A heating time of the heating step (prebaking) is preferably from 1 to 10 minutes, particularly preferably from 1 to 5 minutes.

A heating time of the heating step (curing step) is preferably from 1 to 10 minutes, particularly preferably from 1 to 5 minutes.

Here, "the heating temperature is at most 250°C" means that the temperature of an object to be heated does not exceed 250°C. Substantially, a temperature of a heating device such as a hotplate or an oven may be set to at most 250°C.

In a case where the curing is carried out by photocuring, the curable composition or the coating composition is applied on a substrate to form a coating film, a heating step (prebaking) for the purpose of removing the solvent is carried out as the case requires, then the film is irradiated (exposed) with light, and further, as the case requires, a heating step (curing step) is carried out to obtain a cured film. Light to be applied for curing the film is not particularly limited so long as it is light having a wavelength to which the photopolymerization initiator (C2) contained in the curable composition has a sensitivity. Usually, light to be used for curing is ultraviolet ray, but is not limited thereto.

A wavelength of the light to be applied for curing and a wavelength of laser light to be applied at the time of laser processing may be the same or different.

A heating temperature of the heating step (prebaking) in the case of photocuring is preferably from 30 to 100°C, particularly preferably from 40 to 100°C.

A heating temperature of the heating step (curing step) is preferably from 60 to 200°C, particularly preferably from 100 to 200°C.

A heating time of the heating step (prebaking) is preferably from 1 to 20 minutes, particularly preferably from 1 to 10 minutes.

A heating time of the heating step (curing step) is preferably from 1 to 20 minutes, particularly preferably from 1 to 10 minutes.

### [Laser processing method]

A step of irradiating the cured film with laser light to remove a part of the cured film may be carried out by appropriately employing a known laser ablation processing method.

A wavelength of the laser light is not limited so long as it is a wavelength at which at least the prepolymer (A) or the dye (D) in the cured film has absorption, and an oscillation wavelength of a known laser oscillator may be used.

Specifically, preferred is a wavelength such that the transmittance is at most 98% at the time of letting light having a specific wavelength pass through a 1 µm-thick cured film formed from the curable composition. Particularly preferred is to use a wavelength such that the transmittance is at most 95%.

Further, as a wavelength of the laser light, it is more preferred to use a wavelength at which the prepolymer (A) in the cured film has absorption.

Specifically, the wavelength at which the prepolymer (A) has absorption is preferably a wavelength such that the transmittance is at most 98% at the time of letting light having a specific wavelength pass through a 1 µm-thick cured film formed from the prepolymer (A) alone. Particularly preferred is to use a wavelength such that the transmittance is at most 95%.

The laser oscillator may, for example, be YAG laser, Excimer layer or CO₂ laser.

From the viewpoint of versatility of a device, the oscillation wavelength of laser light is preferably from 190 to 1,100 nm, particularly preferably from 190 to 500 nm.

From the viewpoint that fine processing is possible, and from the viewpoint that the prepolymer (A) in the present invention has absorption in an ultraviolet region, as laser light to be applied to the cured film, especially, ultraviolet laser light (having a wavelength of from 190 to 400 nm, preferably from 230 to 400 nm) is suitably used.

### [Process for producing multilayer wiring structure]

The laser processing method of the present invention may suitably be employed for a step of forming a via hole in an insulation film, in the production of a multilayer wiring structure. That is, it is preferred to form a via hole by a method of irradiating an insulation film made of a cured film obtained by curing the curable composition of the present invention with laser light to remove a part of the film.

The multilayer wiring structure of the present invention is provided with an insulation film which needs to have at least a via hole formed. As an example of the multilayer wiring structure and the insulation film on which a via hole is to be formed, a gate insulation film of an organic thin-film transistor, a gate insulation film of an oxide thin-film transistor, a gate insulation film of a memory transistor, a passivation film of semiconductor devices or an interlayer dielectric film may, for example, be mentioned.

The via hole is a hole piercing an insulation film, and a size or a shape thereof is not limited. In the production process of the present invention, it is possible to form even a fine via hole with good precision. For example, the process is suitably employed for forming a via hole having a diameter of from 1 to 300 µm.

According to the process for producing a multilayer wiring structure of the present invention, by employing a laser ablation processing method, it is possible to form a via hole with good precision by a smaller number of steps than photolithography.

Further, if a substrate of the multilayer wiring structure is a resin substrate, the resin substrate tends to shrink at the time of heat treatment in a step prior to the step of forming a via hole, whereby a position to form a via hole tends to be deviated from an originally designed portion. In such a case, according to the photolithography, it is difficult to correct the deviation of the position to form a via hole since processing is carried out by exposing it with light in accordance with a predetermined design pattern, but on the other hand, according to the process for producing a multilayer wiring structure of the present invention, it is possible to readily correct the deviation of the position to form a via hole by correcting an irradiation position with laser light.

### EXAMPLES

Now, the present invention will be described in detail with reference to Examples, but it should be understood that the present invention is by no means restricted to such specific Examples.

### [Preparation Example 1: Preparation of prepolymer (A1-1)]

Into a 10L glass four-necked flask equipped with a Dimroth condenser, a thermocouple thermometer and a mechanical stirrer, perfluorobiphenyl (650 g), 1,3,5-trihydroxybenzene (117 g) and N,N-dimethylacetamide (hereinafter referred to as "DMAc") (6,202 g) were charged. The mixture was heated on an oil bath with stirring, and when the liquid temperature became 60°C, sodium carbonate (575 g) was quickly added thereto, followed by heating at 60°C for 24 hours with continuous stirring. Then the reaction solution was cooled to 0°C with stirring, 200 g of 4-acetoxystyrene and 532 g of potassium hydroxide were added thereto, followed by further heating at 0°C for 24 hours. Then, the reaction solution was cooled to room temperature, and gradually added dropwise to about 10L of 0.5N aqueous hydrochloric acid solution with vigorous stirring for reprecipitation. The precipitate was collected by filtration, washed twice with pure water and vacuum dried at 60°C for 12 hours to obtain a white powdery prepolymer (A1-1) (800 g).

The obtained prepolymer (A1-1) had an ether bond and a vinyl group as a crosslinkable functional group, and had a number average molecular weight (Mn) of 5,300 (molecular weight calculated as polystyrene, using HLC-8220 manufactured by Tosoh Corporation).

Here, the ether bond is confirmed in such a manner that the vacuum dried prepolymer powder was analyzed by IR (infrared spectroscopy, Nicolet iS10 manufactured by Thermo Scientific K.K.) to confirm absorption in the vicinity of 1,300 cm⁻¹. Further, the crosslinkable functional group was confirmed in such a manner that the vacuum dried prepolymer powder was dissolved in deuterated acetone, and analyzed by ¹H-NMR (nuclear magnetic resonance, JNM-AL300 manufactured by JEOL Ltd.) to confirm signals in a predetermined region. In a case where the crosslinkable functional group is a vinyl group, signals appear in a range of 5=5.0 to 7.0 ppm, and in a case where the crosslinkable functional group is an ethynyl group, signals appear in the vicinity of δ=3.6 ppm.

### (Measurement of transmittance)

A 1 µm-thick cured film made solely of the resulting prepolymer (A1-1) was prepared, and the light transmittance of the cured film at a wavelength of 355 nm was measured by a spectrophotometer UV-3100 (manufactured by Shimadzu Corporation), whereupon it was found to be 95%.

A cured film was prepared in such a manner that the prepolymer (A1 -1) was dissolved in propylene glycol monomethyl ether acetate (PGMEA), then the solution was applied (1,000 revolutions per minute for 30 seconds) on a glass substrate (length (50 mm) × width (50 mm) manufactured by Corning Incorporated) by spin coating, and a coating film thus obtained was heated at 150°C for 20 minutes by a hot plate.

### [Preparation Example 2: Preparation of prepolymer (A1-2)]

In DMAc (492 g), pentafluorostyrene (22 g) and 1,1,1-tris(4-hydroxyphenyl)ethane (33 g) were reacted in the presence of sodium carbonate (51 g) at 60°C for 24 hours in a 1 L glass four-necked flask. Then, a solution having perfluorobiphenyl (40 g) dissolved in DMAc (360 g) was added thereto, followed by further reaction at 60°C for 17 hours to prepare a prepolymer (A1-2). A DMAc solution of the prepolymer (A1-2) obtained was charged to an aqueous hydrochloric acid solution (3.5 mass% aqueous solution) to carry out reprecipitation, and the precipitation was purified and vacuum dried to obtain 75 g of a powdery prepolymer (A1-2).

It was confirmed that the resulting prepolymer (A1-2) had an ether bond and a vinyl group as a crosslinkable functional group, by IR analysis and ¹H-NMR analysis in the same manner as in Preparation Example 1. The number average molecular weight (Mn) was 10,000.

### [Example 1]

In a glass-made sample bottle (20 mL), 1.2 g of the prepolymer (A1-1) as the prepolymer (A), 0.8 g of dipentaerythritol hexaacrylate (tradename: NK ester A-DPH, manufactured by Shin-Nakamura Chemical Co., Ltd., molecular weight: 562, hereinafter referred to as "ADPH") as the compound (B), 0.2 g of benzoyl peroxide (hereinafter referred to as "BPO") as the thermal polymerization initiator (C1) and 8.0 g of PGMEA as a solvent, were put and mixed by using a shaker to obtain a coating composition (1).

The coating composition (1) obtained was applied on a glass substrate (manufactured by Corning Incorporated, length (50 mm) × width (50 mm)) by a spin coating method (MS-A100 manufactured by Mikasa Co., Ltd.). Spin conditions were 1,000 revolutions per minute for 30 seconds. The resulting coating film was heated at 150°C for 20 minutes by a hot plate to obtain a 1 µm-thick cured film.

By using an UV-YAG laser oscillator (tradename: AVIA Ultra 355-2000, manufactured by Coherent), a prescribed position of the cured film obtained as the above was irradiated with laser light having a beam diameter of 80 µm. A via hole having a diameter of 10 µm was formed by one shot irradiation with 0.064 mJ of energy per pulse at an oscillation wavelength of 355 nm, as irradiation conditions.

### [Example 2]

In a glass-made sample bottle (20 mL), 1.2 g of the prepolymer (A1-1) as the prepolymer (A), 0.8 g of ADPH as the compound (B), 0.2 g of BPO as the thermal polymerization initiator (C1), 0.1 g of a hydroxyphenyltriazine type ultraviolet absorber (tradename: TINUVIN 479 manufactured by BASF) represented by the following formula (I) as the dye (D) and 8.0 g of PGMEA as a solvent were charged and mixed by using a shaker to obtain a coating composition (2).
The formula (I):

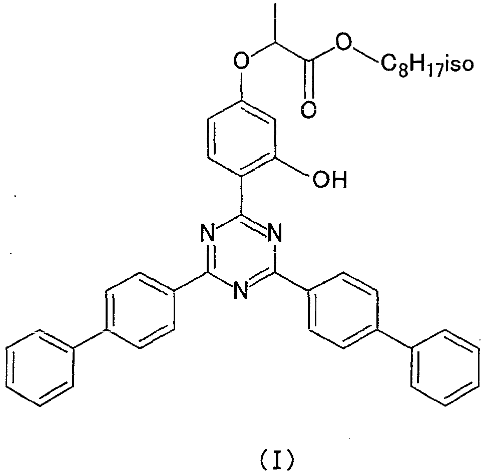

By using the coating composition (2) obtained, a 1 µm-thick cured film was formed on a glass substrate in the same manner as in Example 1.

By using the same UV-YAG laser oscillator as in Example 1, a prescribed position of the cured film obtained as the above was irradiated with laser light having a beam diameter of 80 µm. A via hole having a diameter of 10 µm was formed by one shot irradiation with 0.001 mJ of energy per pulse at an oscillation wavelength of 355 nm as irradiation conditions.

In Example 2, since the dye (D) was contained in the coating composition, in the laser processing, it was possible to remarkably lower the energy per pulse than in Example 1.

### [Example 3]

A coating composition (3) was obtained in the same manner as in Example 1 except that the prepolymer (A) was changed to the prepolymer (A1-2).

By using the coating composition (3) obtained, a 1 µm-thick cured film was formed on a glass substrate in the same manner as in Example 1.

By using the same UV-YAG laser oscillator as in Example 1, a prescribed position of the cured film obtained as the above was irradiated with laser light having a beam diameter of 80 µm. A via hole having a diameter of 10 µm was formed by one shot irradiation with 0.064 mJ of the energy per pulse at an oscillation wavelength of 355 nm as irradiation conditions.

### [Example 4]

A coating composition (4) was obtained in the same manner as in Example 2 except that the prepolymer (A) was changed to the Prepolymer (A1-2).

By using the coating composition (4) obtained, a 1 µm-thick cured film was formed on a glass substrate in the same manner as in Example 1.

By using the same UV-YAG laser oscillator as in Example 1, a prescribed position of the cured film obtained as the above was irradiated with laser light having a beam diameter of 80 µm. A via hole having a diameter of 10 µm was formed by one shot irradiation with 0.001 mJ of the energy per pulse at an oscillation wavelength of 355 nm as irradiation conditions.

In Example 4, since the dye (D) was contained in the coating composition, in the laser processing, it was possible to remarkably lower the energy per pulse than in Example 3.

### [Comparative Example 1]

In Example 1, CYTOP CTL-809M (tradename: manufactured by Asahi Glass Company, Limited, a perfluoropolymer having an alicyclic structure in its main chain) was used instead of the coating composition (1).

The solution was applied on a glass substrate by a spin coating method in the same manner as in Example 1, and then heated at 200°C for 10 minutes by a hot plate to obtain a 1 µm-thick cured film.

A prescribed position of the cured film was irradiated with laser light under the same conditions as in Example 1, whereupon no laser ablation occurred and no via hole was formed.

### INDUSTRIAL APPLICABILITY

By using the curable composition of the present invention, it is possible to obtain a cured film having a low dielectric constant, a low water absorption and further being processable by means of a laser ablation method in which a part of a cured film is removed by irradiation with laser light. In a case where the cured film is used as an insulation film, by the laser processing method of the present invention, it is possible to carry out processing with good precision with a small number of steps, it is possible to produce a multilayer wiring structure having a via hole formed with good precision by a small number of steps, and it is useful as e.g. a gate insulation film of an organic thin-film transistor.

The entire disclosure of Japanese Patent Application No. 2011-252663 filed on November 18, 2011 including specification, claims and summary is incorporated herein by reference in its entirety.

## Claims

1. A curable composition for obtaining a cured film a part of which is to be removed by irradiation with laser light, which comprises a fluorinated polyarylene prepolymer (A) having a crosslinkable functional group.

2. The curable composition according to Claim 1, wherein the content of the fluorinated polyarylene prepolymer (A) in the curable composition is from 10 to 100 mass%.

3. The curable composition according to Claim 1 or 2, which further contains a compound (B) having a number average moiecuiar weight of from 140 to 5,000, having at least two crosslinkable functional groups and having no fluorine atoms.

4. The curable composition according to any one of Claims 1 to 3, which further contains a radical polymerization initiator (C).

5. The curable composition according to any one of Claims 1 to 4, which further contains a dye (D) for absorbing laser light for the irradiation.

6. The curable composition according to any one of Claims 1 to 5, wherein the fluorinated polyarylene prepolymer (A) is a polymer having a crosslinkable functional group and an ether bond, obtained by subjecting either one or both of a compound (Y-1) having a crosslinkable functional group and a phenolic hydroxy group and a compound (Y-2) having a crosslinkable functional group and a fluorinated aromatic ring, a fluorinated aromatic compound (Z1) represented by the following formula (1): 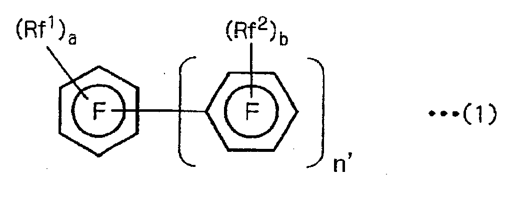 (wherein n' is an integer of from 0 to 3, each of a and b which are independent of each other, is an integer of from 0 to 3, each of Rf¹ and Rf² which may be the same or different from each other, is a fluorinated alkyl group having at most 8 carbon atoms, and F in the aromatic ring represents that hydrogen atoms of the aromatic ring are all substituted by fluorine atoms), and a compound (Z2) having at least three phenolic hydroxy groups, to a condensation reaction in the presence of a HF-removing agent.

7. A coating composition comprising the curable composition as defined in any one of Claims 1 to 6 and a solvent.

8. A cured film obtainable by forming a coating film from the curable composition as defined in any one of Claims 1 to 6 or the coating composition as defined in Claim 7, removing the solvent as the case requires, and then curing the coating film by thermosetting or photocuring.

9. A laser processing method comprising a step of irradiating the cured film as defined in Claim 8 with laser light to remove a part of the film.

10. The laser processing method according to Claim 9, wherein the cured film has a thickness of from 0.1 to 100 µm.

11. The laser processing method according to Claim 9 or 10, wherein the laser light has an oscillation wavelength of from 190 to 1,100 nm.

12. A process for producing a multilayer wiring structure, comprising a step of irradiating an insulation film made of the cured film obtained by curing the curable composition with the laser light, to form a via hole, by means of the laser processing method as defined in any one of Claims 9 to 11.
